# EUROPEAN PATENT SPECIFICATION

(11) **EP 0 899 576 B1**
(45) Date of publication and mention of the grant of the patent: **14.09.2005**
(21) Application number: 98830463.0
(22) Date of filing: 30.07.1998
(51) Int. Cl.: G01R 33/389

(54) **System for active compensation of magnetic field disturbances in nuclear magnetic resonance tomography**
System zur aktiven Kompensation von Magnetfeldstörungen in der Kernspintomographie
Système pour la compensation active de perturbations du champ magnétique dans la tomographie à résonance magnétique nucléaire

(30) Priority: 01.08.1997 IT RM970486
(43) Date of publication of application: 03.03.1999
(73) Proprietor: ITEL Telecomunicazioni S.r.l., 70037 Ruvo di Puglia (BA) (IT)
(72) Inventor: Diaferia, Leonardo, 70037 Ruvo di Puglia (BA) (IT)
(74) Representative: Gervasi, Gemma

(56) References cited:
- DE-A- 19 510 142
- JP-A- 2 045 035
- JP-A- 3 151 936
- JP-A- 5 300 896
- JP-A- 6 181 903
- US-A- 5 214 383
- US-A- 5 278 503
- J.A.POHJONEN ET AL.: "Compensation of Magnetic Field Instabilities in MRI" BOOK OF ABSTRACTS, VOL. 2, SOCIETY OF MAGNETIC RESONANCE IN MEDICINE, EIGTH ANNUAL MEETING AND EXHIBITION, AUGUST 12-18, 1989, AMSTERDAM, THE NETHERLANDS, page 968 XP002083046

## Description

### Technical Field

The system has the purpose to lessen the magnetic field disturbance, almost static or slowly unsteady (frequency band <100 Hz) that can interest NMR Tomographs placed near moving metal masses, electric cables, either DC or Ac, etc. and could therefore compromise their proper operation.

### Background of art

The new-generation Tomographs (active shield) characterised by a very low dispersed magnetic field and very fast acquisition sequence are very sensitive to external magnetic field changes that, if they arise during the acquisition phases could cause alterations of image. Presently there are no commonly used magnetic field probes that can perceive slight variations of B, in the order of tenths of Gauss, in the presence of a very high background field, in the order of 15.000 Gauss, such as the one generated by a NMR Tomograph.

This technical and manufacturing limitation of B field probes has not allowed to use the classic closed loop compensation systems that can act directly on the machine disturbances and that represent the state of the art for active systems for compensation of magnetic field for other applications.

Changes in the B magnetic field with respect to a background value (represented for example by the terrestrial magnetic field) may represent a problem for all the scientific and/or technical machines that require to be plunged into a constant field in order to operate correctly. At present, the solution of this problem is given by the passive shielding by means o ferromagnetic materials and by active systems for compensation of the disturbances.

When using the passive systems, a ferromagnetic shield is placed between the source of disturbances and the machine to be protected. The function of this shield is to channel inside it the flow lines of the undesired magnetic field dissipating them into the volume to be protected.

In lessening the variations of B that interest NMR Tomographs, this solution raises serious problems. The lessening levels required to that the disturbances are not harmful for the machine can be obtained with acceptable thickness only by means o highly permeable materials such as mumetal or permalloy which, besides being costly, have low saturation levels. Such materials, inserted in the high dispersed magnetic field of the Tomograph, may saturate and become practically transparent to the disturbances to be shielded.

In the active compensation systems magnetic field disturbances are lessened by means of an equal and contrary field generated by appropriate coils placed according to the Helmoutz configuration.

At present there exist compensation systems used to lessen the magnetic field of disturbances on electronic microscopes and other laboratory devices.

In such applications, characterised by a low dispersed magnetic field of the machine , the probe that can perceive the field of disturbances may be placed near the sensitive element of the machine to be protected. Such positioning of the probe enables the use of the classic scheme of retroaction control, thus remarkably simplifying both machine operation and system set up. This solution cannot be used for NMR Tomographs , because at present there are no magnetic field probes that can perceive variations of milliGauss over a backgrouund dispersed field of 10.000Gauss. In order to overcome this limitation it has therefore been decided to place the probe at a distance from the magnet that may ensure background field values compatible with the required sensitivity of sensor.

The compensation systems at present on the market, moreover, for generating the correction field use coils placed at the corners of the room containing the machine to be protected. This is once again an effective measure in the case of compensation systems for machines that have not a high dispersed magnetic field, but cannot always be used in the case of NMR Tomographs. The magnetic field generated inside these diagnostic systems must be confined within a controlled volume, for security reasons concerning persons and machines, and in many cases this requires the placement of adequate ferromagnetic shields on the walls of the test room. In presence of these shields, in case the magnetic field correction coils should be placed in the corners of the room, just near ferromagnetic materials, the B field flow would be conveyed in the high permeability materials, with a significant distortion of the correction field.

The proceedings of the 8th annual meeting of the SMRM, on p. 968, disclose a system for the compensation of external magnetic field instabilities in MRI which comprises a fluxgate magnetometer probe installed at 1.5 m from the centre of the main magnetic field and operated in zero-lock mode. The signal from the magnetometer controls the compensation current in a Helmholtz coil wound around the magnet. The Earth's magnetic field and the fringe field of the MRI magnet at the probe position are offset with a small coil wound around the probe.

DE-A-195 10 142 discloses a similar system in which a fluxgate probe is located above the upper yoke of a C-shaped open MRI magnet and is shielded from the stray field of the magnet by means of an auxiliary coil. Filtering means are provided for making sure that the temporal variation of the compensation magnetic field equals the temporal variation of the external magnetic field disturbances inside the examination volume.

US-A-5 278 503 discloses an open loop control system for the cancellation of external magnetic field disturbances in which induction coils are used as field sensors.

JP-A-05-300896 also discloses an open loop control system in which, however, a field sensor is used which is actively shielded from both the fringe field of the MRI magnet and the field generated by the compensation coils.

### Disclosure of invention

The present invention is defined in claim 1. The subject system is completely automatic and it carries out compensation of the external magnetic field by means of an open loop control through a correction curve defined during the setting phase.

The operation principle of this systems is the following: in presence of a B noise field of disturbances read by a magnetic field probe placed at an adequate distance from the magnet, the system automatically generates according to a transfer function (B nois ?I corr), an Icorr current (t) that circulates in the correction coils placed according to the Helmoutz configuration, so as to cancel the disturbances on the Tomograph (Btom).

What above involves that the correction is not made acquiring directly the value of B nois field that is later correlated, during the setting phase to the effects that the machine disturbance field (Btom) has on it in terms of variations of the resonance frequence.

This systems is particularly adapted for the compensation of variations of magnetic field, even triaxial on NMR Tomographs. The systems has a modular structure that enables to move from a monoaxial to a triaxial configuration. Moreover it has a PC interface system via RS 232 that allows it to be used also as a systems for monitoring magnetic fields.

Such systems is essentially composed of:
a perceiving unit
a control unit
a correction coil.

The perceiving unit is made of a Fluxgate-type probe and of a pre-amplification stage, and it is intended to provide to the control unit only the field variations with respect to a background value, due to the terrestrial magnetic field and to the dispersed field of Tomograph. The probe can be either mono or triaxial, according to the type of disturbance, and it is able to perceive an absolute B field value, namely background field + disturbance.

Pre-amplification phase is intended to extract and amplify only B field variations with respect to the background field and for this purpose it is equipped with an offset adjuster for the definition of the background field value. At the exit of this block we find the B field of disturbances that is adjusted to the machine disturbances during the setting phase.

The control block is the intelligent unit that can provide with respect to the exit signal from the perceiving block a current that circulates in the correction coils for generating the counter-field.

The characteristic of transfer Bnoise⇒ is defined during the setting phase when the dedicated software system is also prepared, and it is stored in a non-volatile memory inside the unit.

The control unit hardware is fed by a 220V AC 6 it is composed of an analogic digital converter (ADC) , a microcomputer signal processor (DSP) an analogic digital converter (DAC) and a power stage; the systems is modular and it can be equipped with 1 to 3 correction modules that, according to the disturbance to be lessened can be either monoaxial, biaxial or triaxial.

The correction coils are intended to generate, when the exit current from the control unit passes through them, the magnetic counter-field. They are placed according to Helmoutz configuration along the Tomographs axes according to which the disturbance have to be lessened. Therefore, there can be from a minimum of a couple of coils to a maximum of three couples placed along three axes X,Y and Z of the machine. Both the position and the number of coil curls are defined from time to time according to the characteristics of the disturbances to be lessened.

### Brief description of the drawings

The invention systems, from now on referred to as DIAMAGS, will be now described with reference to a preferred form that is not restrictive of the invention illustrated in the annexed drawings in which:
Figure 1 shows the block scheme of the invented system.
Figure 2 shows a scheme of the transfer characteristics Bnoise ⇒ Icorr
Figure 3 shows a principle configuration of a monoaxial systems according to this invention.
Figure 4 shows a preferred scheme of the sensor pre-amplifier.
Figure 5 shows the circuit scheme of pre-amplifier.
Figure 6 and 7 show respectively the circuit schemes of the elaboration section and of acquired signals.
Figure 8 shows the preferred circuit scheme of the analogic digital converter.
Figure 9 shows the preferred scheme of the feeder.

### Description of a preferred embodiment of the invention.

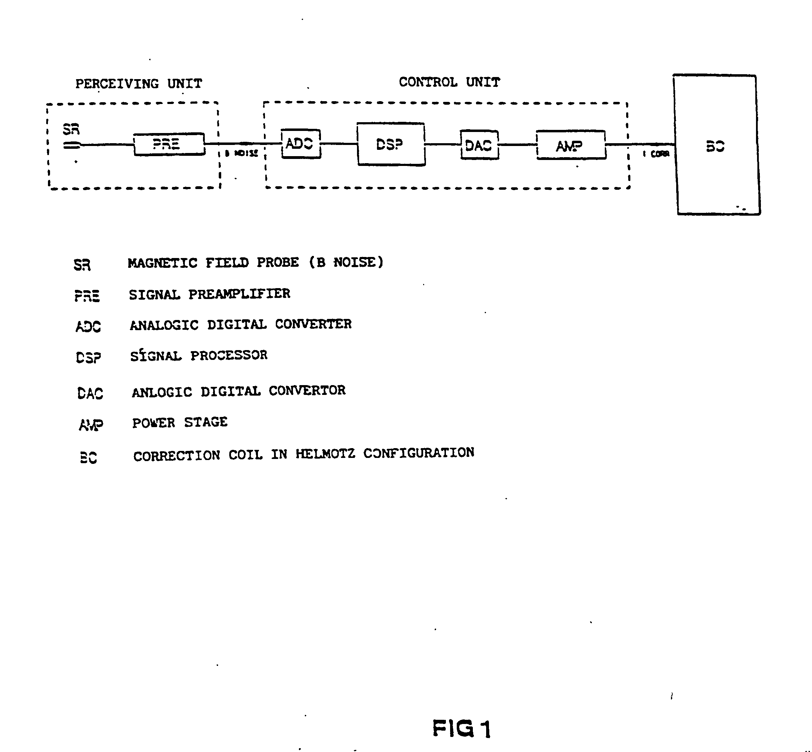

With reference to the above Figures, and especially to Figure 1 that shows the block scheme of the system, the perceiving unit that includes a Fluxgate probe and a pre-amplification stage, and it is intended to provide to the control unit, in presence of the absolute field value (Bbackground+Bnoise) perceived by the probe, only the field variations (Bnoise) with respect to a background value,B background) due to the terrestrial magnetic field and to the dispersed field of Tomograph.

The probe of a preferred configuration has the following characteristics :
band width: 0ö3k Hz
measuring range: ±250 u T
output impendance: <1Ω
calibration accuracy: ±0,5%
internal noise: 4-6pTrms/ Hz to 1 Hz
scaling: 40mV/µ T
offset error: ±12nT

The probe can be monoaxial, biaxial or triaxial, according to the type of disturbances and therefore the system configuration. The preamplifier, cascade connected to the probe has the purpose to "extract" and amplify only the variations of Bnoise field with respect to the background field and is equipped with an offset adjuster for the definition of a reference tension value related to the background field value. Offset adjustment is carried out during the setting phase of the system.

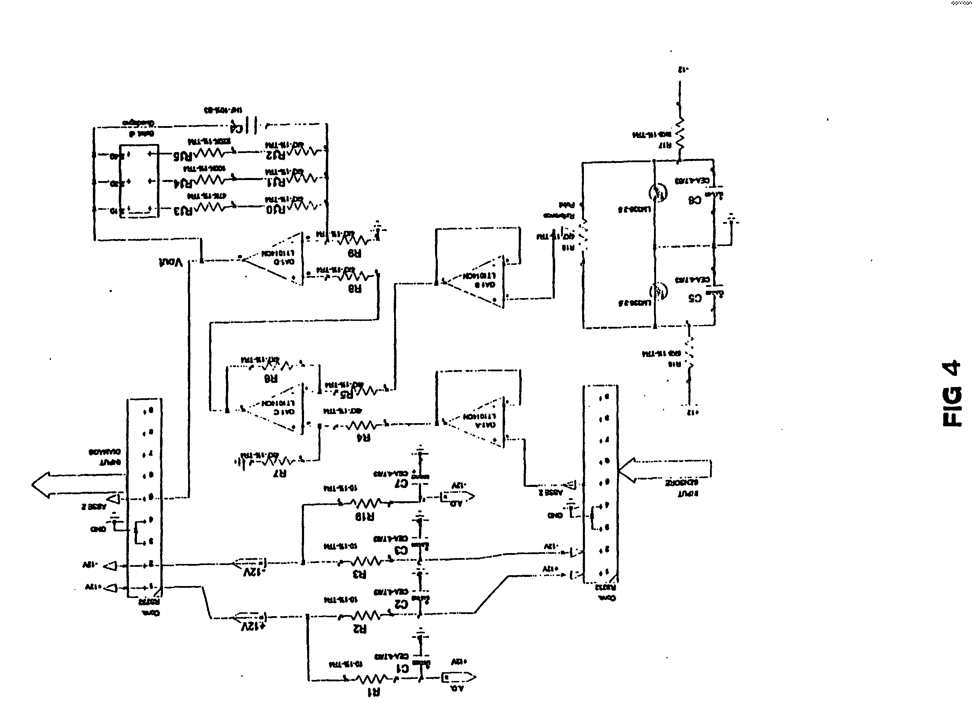

Figure 4 shows the circuit scheme of the pre-amplifier and outwards interfaces: on one side the output of the RS232 serial Fluxgate probe and on the other side the output towards the invention machine, which is also an RS232 device.

The pre-amplifier is equipped with a variable gain amplifier which, in presence of the maximum selected input value generates a 5VDC input tension at the stage of analogic-digital conversion of DIAMAGS.

Connection between pre-amplifier and DIAMAGS is made by means of a RS232 multipolar shielded cable both for feeding and for the signals.

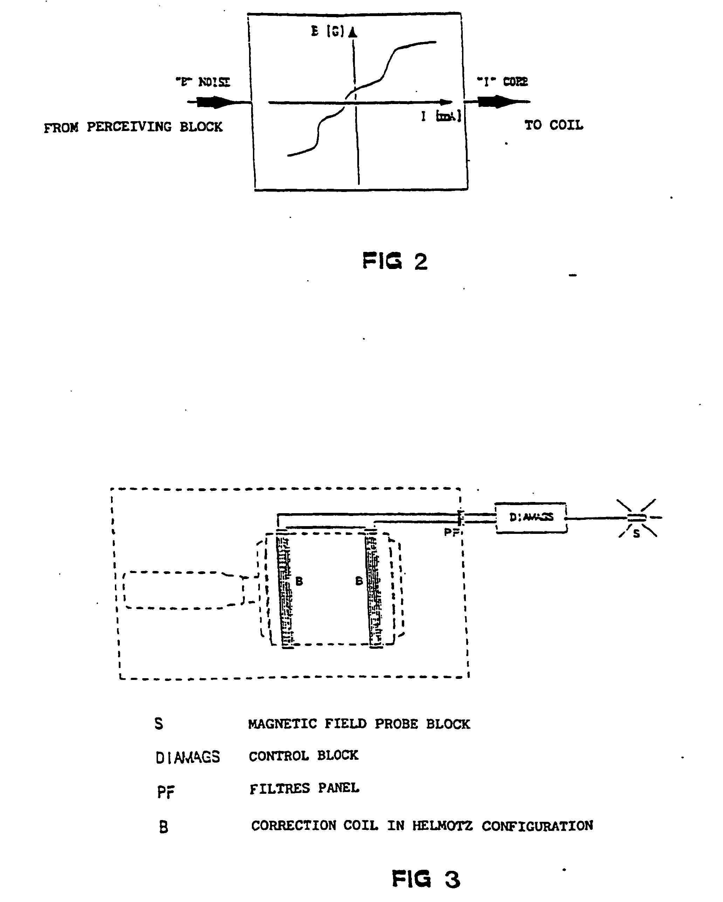

As indicated above, the DIAMAGS control and monitoring unit is a fundamental section both as to innovation and as for the importance of the invented system. The control and monitoring DIAMAGS unit that can be seen in the block system in Figure 1 is an intelligent unit which can provide, in presence of the output Bnoise from the perceiving block an Icorr correction current for generating the compensation counter-field. The correction is made taking into account the transfer characteristic Bnoise⇒Icorr shown in the annexed Figure 2, defined during the setting phase and stored stored in a non-volatile memory inside the unit.

The unit may be moreover interfaced to a via RS232, both for adjustment and for monitoring the disturbance by means of an adequate software especially studied and carried out by the patent inventor.

The monitoring and control unit is characterised by a modular structure for monoaxial, biaxial or triaxial configurations. All the hardware for acquisition, monitoring and control relative to an axis is contained on one single card which may be connected on bus to the mother board of the machine. Modularity of the machine enables to create highly reliable redundant structures.

The machine can be fed by 220 or 100 V current and is equipped with the following interfaces;
serial port with 9PIN Cannon connection for communicating with the perceiving unit;
1,5 mmq three-pole feeding cable;
9 pin Sub D Miniature serial port for communication with PC;
2 analogic output with BNC connector for monitoring the input signal to the unit, before and after the pre-amplification stage;
clamps for feeding both the correction and error coils;
three LEDs, two of whom for the percentage indication of the output signal from the perceiving block and of the correction current, while the third is for measuring the circulating within the correction coils.

The monitoring and control unit is composed of the following block and /or sections
⇒ pre-amplifier
⇒ computer
⇒ feeder

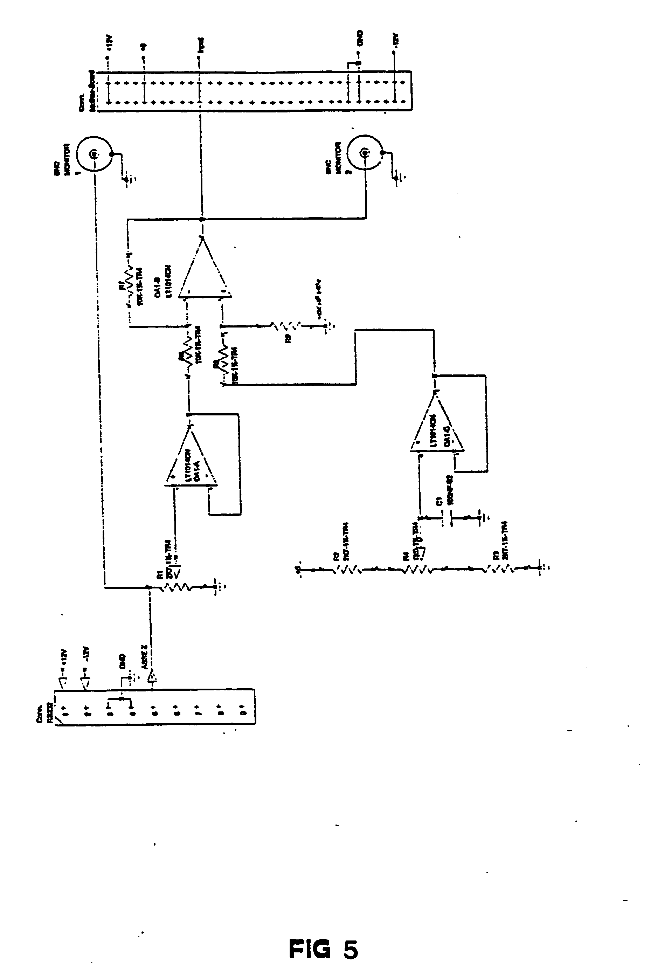

The pre-amplifier whose scheme is shown in Figure 5 has the purpose to adapt the impedance and making the output signal from the perceiving block compatible with the ADC conversion stage. On one side it can be noted RS232 connection with the perceiving probe, and on the other the output of the adapted signal towards the ADC converter of the computer section. There are also two BNC outputs to the monitor for displaying the signal perceived before and after this stage.

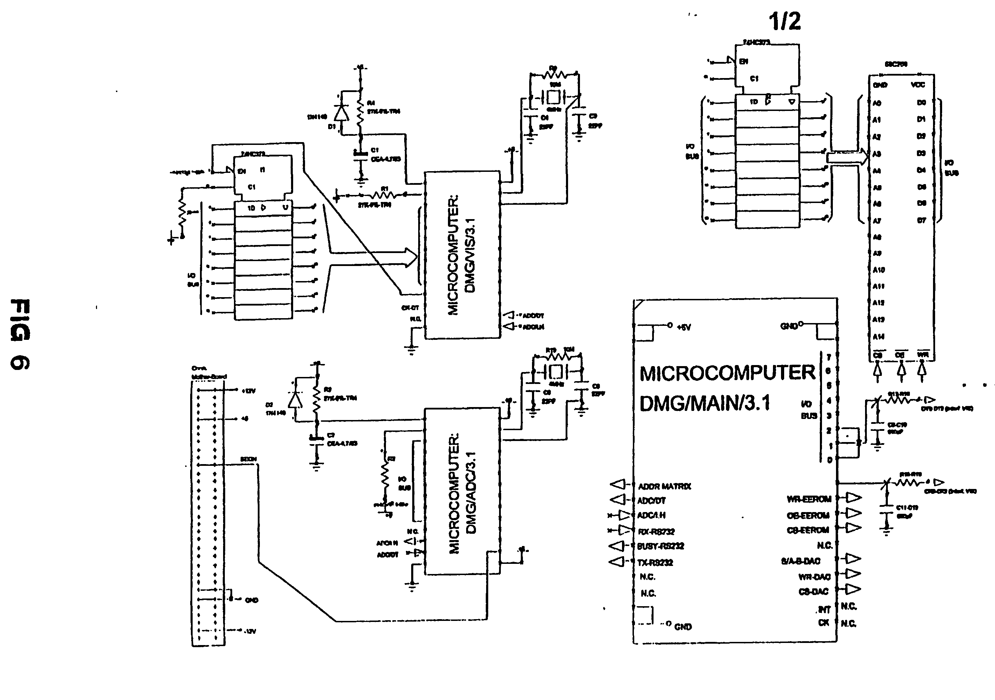

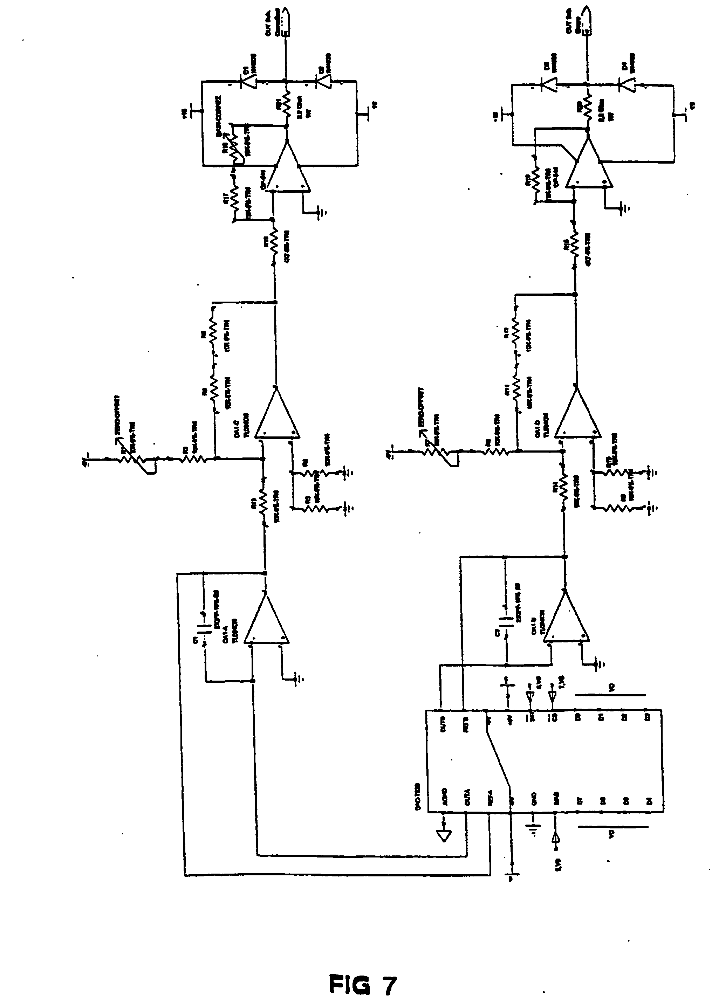

Figures 6 and 7 show the circuit schemes of the computer section intended to elaborate and process the perceived signals, whose aim is to read the input analogic values, converting them into digital signals and , referring to the setting curve, defining the output controls in numeric form. ADC conversion is carried out by the DMG/ADC/3.1 block, whose output is processed by the micro computer DMG/MAIN/3.1, which, on the basis of the informations contained in EEROM, which are programmed and stored during the setting phase if the machine defines the various digital actuations which then go as an input to the following block. This section is moreover composed by the display block, the DMG/VIS/3.1 micro computer and the Visual interface which is the RS232 interface to the PC.

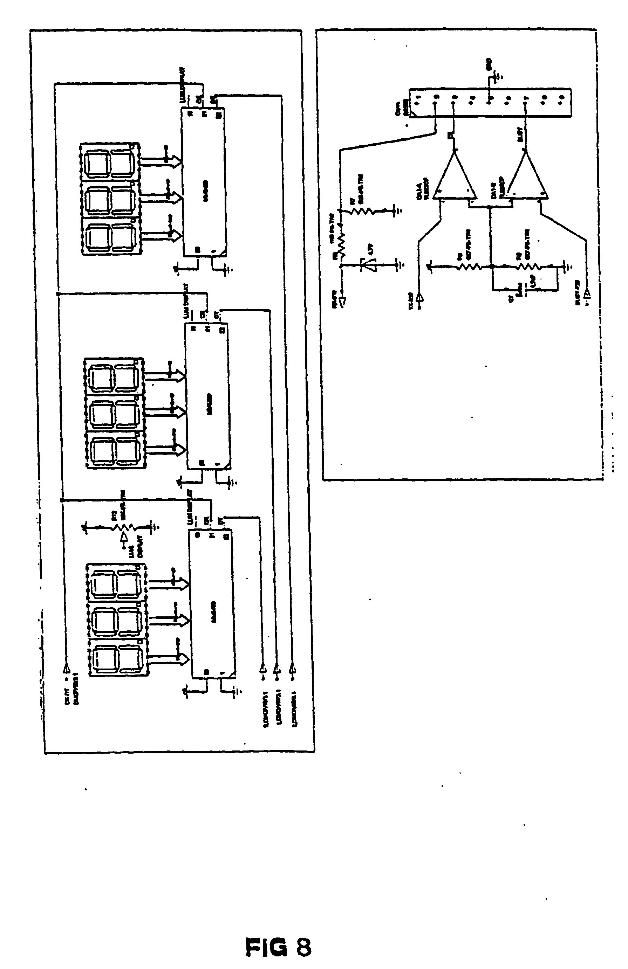

Figure 8 shows the circuit scheme of DAC section which represents the actuation circuit that receives the digital controls from the previous section, converts them into analogic signal amplifying them in order to feed correction coils. The section includes the driving stage of another coil (error coil) which can be used in the setting phase or in the characterisation of the magnet. The output of the correction coil can be handled either automatically by the system during compensation phases or manually by interfacing it with the PC during the setting phase.

The output of the error coil can instead be used manually through one of the procedures of the setting software of the system.

The circuit scheme of this section is shown in Figure 8.

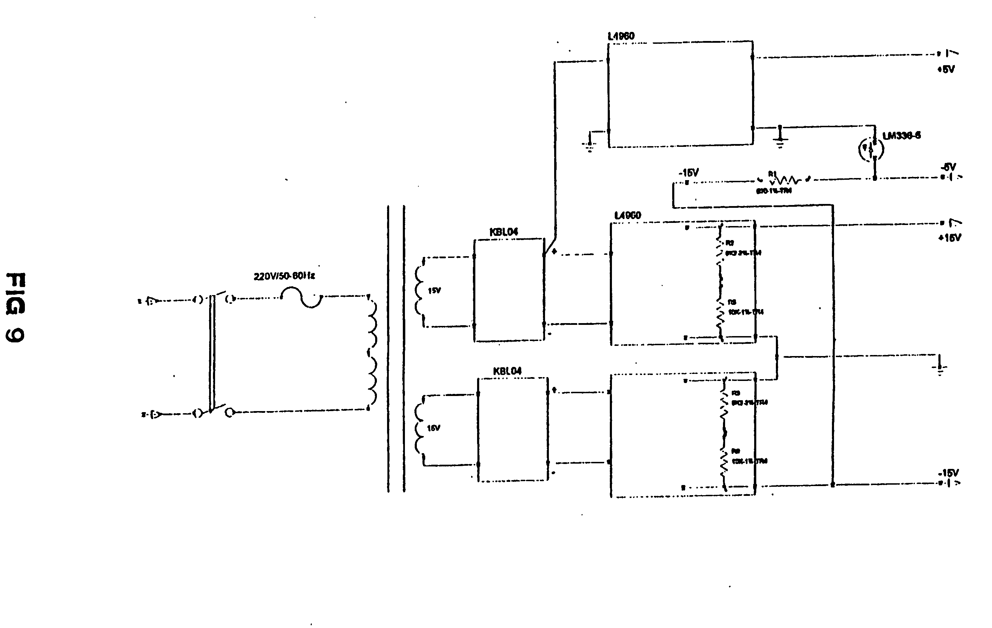

Figure 9 shows the circuit scheme of the feeding section, which provides feeding to both the digital section (+5V) and the analogic section (+ 15V) starting from the network tensions (220V/110Vac 50/60 Hz).

Figure 3 shows the configuration of a monoaxial DIAMAGS system, evidencing the fundamental blocks and the insertion scheme of coils on the Tomograph.

Correction coils, crossed by the output current coming from the control unit DIAMAGS, generate the magnetic counter-field for compensation of the disturbances. They are placed in Helmoutz configuration along the axes of the Tomograph for which the disturbances are to be lessened; it is therefore possible to have from a minimum of a couple of coils to a maximum of three couples placed along three axes X,Y and Z of the machine. Both the position and the number of coil curls are defined from time to time on the basis of the characteristics of the disturbances to be lessened. It is evident that for the proper operation of the system and in order to fully exploit its potential, it is essential that the setting is properly carried out. The setting phase has the aim to define the correction curve (or historic matrix) which will be then automaticaly recalled by the systems in order to generate, in presence of a disturbance Bnoise in output from the perceiving unit an Icorr current. Since it is not possible to perceive directly the disturbance that characterises the magnet, as no B-field probes may be found on sale that could perceive small field (around 15.000 Gauss) the disturbances read by the probe placed at an appropriate distance from the magnet has been related to the effects that the B-field variation causes on the machine in terms of drift of the resonance frequence. This involves the simultaneous perception, for a certain period, of both the variation of the resonance frequence of the Tomograph and of the variation of B-field, observed by the latter, through the perception unit whose position is defined during site audit.

The steps which characterise the setting procedure are the following:
adjustment of the offset of the perceiving unit;
correlation of the disturbance read by the perceiving unit (Bnoise) to the drift of resonance;
frequence of the magnet;
characterisation of the system composed by the magnet and the correction coils;
definition and storing of the correction curve Bnoise⇒Icorr.

The above mentioned setting operations are carried out according a guided procedure,
connecting DIAMAGS unit to a PC through the RS232 serial port by means of a dedicated
software carried out by the patent inventor.

## Claims

1. Open loop control system for the active compensation of almost static or slowly unsteady external magnetic field disturbances of the main static magnetic field of an NMR tomograph, said system comprising:
- a perceiving unit comprising a fluxgate magnetic field probe arranged to be placed in the stray magnetic field of the main static magnetic field of the NMR tomograph,
- a control, monitoring and setting unit, and
- correction coils arranged to be mounted according to a Helmholtz configuration and to generate a counterfield opposing the component of the external magnetic field disturbances along at least one predetermined direction,
wherein
- said fluxgate probe is arranged to perceive an absolute field value given by the sum of a background field value, due to the terrestrial magnetic field and to said stray magnetic field, and a value Bnoise of said external magnetic field disturbances,
- said perceiving unit comprises means for providing said control, monitoring and setting unit with only said value Bnoise of said external magnetic field disturbances and, to this end, comprises a preamplifier which is cascade connected to the fluxgate probe and is arranged to extract and amplify only said value Bnoise of said external magnetic field disturbances and, for this purpose, is equipped with an offset adjuster for the definition of a reference tension value related to said background field value, and
wherein
- said control, monitoring and setting unit is arranged to automatically generate, according to a transfer function Bnoise => Icorr defined during a setting phase, a time-dependent Icorr current which is supplied to said correction coils, so as to generate said counterfield for cancellation of said component of said external magnetic field disturbances.

2. Open loop control system according to claim 1, **characterised in that** said control, monitoring and setting unit has a modular structure for monoaxial, biaxial or triaxial configuration, and **in that** said correction coils comprise from a minimum of one couple of coils to a maximum of three couples of coils placed along three axes x, y, z.

## Patentansprüche

1. Steuersystem zur aktiven Kompensation nahezu statischer oder langsam nichtstationärer externer Magnetfeldstörungen des statischen Hauptmagnetfelds eines NMR-Tomographen, wobei das genannte System umfasst:
- eine Wahrnehmungseinheit, die eine Magnetfeldmesser-Magnetfeldsonde umfasst, die so beschaffen ist, dass sie in dem Streumagnetfeld des statischen Hauptmagnetfelds des NMR-Tomographen angeordnet ist,
- eine Steuerungs-, Überwachungs- und Einstelleinheit, und
- Korrekturspulen, die so beschaffen sind, dass sie gemäß einer Helmholtz-Konfiguration angebracht sind und dass sie wenigstens längs einer vorgegebenen Richtung ein Gegenfeld erzeugen, das der Komponente der externen Magnetfeldstörungen entgegengesetzt ist,
wobei
- die genannte Magnetfeldmesser-Magnetfeldsonde so beschaffen ist, dass sie einen Feldabsolutwert wahrnimmt, der durch die Summe eines Hintergrundfeldwerts wegen des Erdmagnetfelds und wegen des genannten Streumagnetfelds und eines Werts Bnoise der genannten externen Magnetfeldstörungen gegeben ist,
- die genannte Wahrnehmungseinheit Mittel umfasst, um an die genannte Steuerungs-, Überwachungs- und Einstelleinheit nur den genannten Wert Bnoise der genannten externen Magnetfeldstörungen zu liefern, wobei sie dazu einen Vorverstärker umfasst, der mit der Magnetfeldmesser-Magnetfeldsonde in Reihe geschaltet und so beschaffen ist, dass er nur den genannten Wert Bnoise aus den genannten externen Magnetfeldstörungen auskoppelt und verstärkt, wobei er hierfür mit einer Versatzanpassungseinrichtung zur Definition eines auf den genannten Hintergrundfeldwert bezogenen Referenzspannungswerts ausgestattet ist, und wobei
- die genannte Steuerungs-, Überwachungs- und Einstelleinheit so beschaffen ist, dass sie gemäß einer während einer Einstellphase definierten Übertragungsfunktion Bnoise => ICorr automatisch einen zeitabhängigen Strom Icorr erzeugt, der den genannten Korrekturspulen zugeführt wird, um das genannte Gegenfeld zur Auslöschung der genannten Komponente der genannten externen Magnetfeldstörungen zu erzeugen.

2. Steuersystem gemäß Anspruch 1, **dadurch gekennzeichnet, dass** die genannte Steuerungs-, Überwachungs- und Einstelleinheit eine modulare Konstruktion für eine einachsige, zweiachsige oder dreiachsige Konfiguration aufweist und dass die genannten Korrekturspulen von wenigstens einem Spulenpaar bis zu höchstens drei Spulenpaare umfassen, die entlang der drei Achsen x, y, z angeordnet sind.

## Revendications

1. Système de commande en boucle ouverte pour la compensation de perturbations de champs magnétiques externes presque statiques ou lentement instables du champ magnétique statique principal d'un tomographe à résonance magnétique nucléaire, ledit système comprenant :
- une unité capteur comprenant une sonde à champs magnétique et à entrefer disposée pour être placée dans un champ magnétique parasite du champ magnétique statique principal du tomographe à résonance magnétique nucléaire,
- une unité de commande, de surveillance et de réglage, et
- des bobines de correction disposées pour être montées selon une configuration de Helmholtz et pour générer un contre-champ opposé au composant des perturbations du champ magnétique externe le long d'au moins une direction prédéterminée,
dans lequel système :
- ladite sonde à entrefer est disposée pour capter une valeur de champ absolue donnée par la somme d'une valeur de champ de fond , due au champ magnétique terrestre et audit champ magnétique parasite, et une valeur Bnoise desdites perturbations de champ magnétique externes,
- ladite unité capteur comprenant des moyens de fourniture de ladite unité de commande, de surveillance et de réglage avec uniquement ladite valeur Bnoise desdites perturbations de champ magnétique externes, et ladite unité de capteur comprend à cette fin un préamplificateur qui est connecté en cascade à la sonde à entrefer et est disposé pour extraire et amplifier uniquement ladite valeur Bnoise desdites perturbations de champ magnétique externes tout en étant équipée à cette fin d'un régleur de décalage pour la définition d'une valeur de tension de référence pour ladite valeur de champ de fond, et
- ladite unité de commande, de surveillance et de réglage étant disposée pour générer automatiquement selon la fonction de transfert Bnois → Icorr définie pendant la phase de réglage, un courant Icorr dépendant du temps fourni auxdites bobines de correction, de manière à générer ledit contre-champ destiné à annuler ledit composant desdites perturbations de champs magnétique externes.

2. Système de commande en boucle ouverte selon la revendication 1, **caractérisé en ce que** ladite unité de commande, de surveillance et de réglage a une structure modulaire pour une configuration monoaxiale, biaxiale ou trixiale , et **en ce que** lesdites bobines de correction comprennent des bobines allant au minimum d'un couple de bobines vers un maximum de trois couples de bobines placées le long de trois axes x, y et z.
